# EUROPÄISCHE PATENTSCHRIFT

(11) **EP 3 277 858 B1**
(45) Veröffentlichungstag und Bekanntmachung des Hinweises auf die Patenterteilung: **23.01.2019**
(21) Anmeldenummer: 16718210.4
(22) Anmeldetag: 01.04.2016
(51) Int. Cl.: C23C 14/50, C23C 16/458, B05B 13/02

(54) **CHARGIERUNG VON WERKSTÜCKEN IN EINER BESCHICHTUNGSANLAGE**
LOADING OF WORKPIECES IN A COATING SYSTEM
CHARGEMENT DE PIÈCES DANS UNE INSTALLATION DE REVÊTEMENT

(30) Priorität: 02.04.2015 DE 102015105169
(43) Veröffentlichungstag der Anmeldung: 07.02.2018
(73) Patentinhaber: CemeCon AG, 52146 Würselen (DE)
(72) Erfinder: KÖLKER, Werner, 52134 Herzogenrath (DE); MAY, Walter, 52078 Aachen (DE)
(74) Vertreter: Kalkoff & Partner
(86) Internationale Anmeldenummer: PCT/EP2016/057279
(87) Internationale Veröffentlichungsnummer: WO 2016/156601

(56) Entgegenhaltungen:
- WO-A1-2007/008972
- DE-A1-102013 007 454
- JP-A- S63 255 369
- JP-U- H0 217 552
- US-A1- 2013 264 169
- US-B1- 6 866 889

## Beschreibung

Die Erfindung betrifft die Chargierung von Werkstücken in einer Beschichtungsanlage, insbesondere eine Chargiervorrichtung hierfür, eine hiermit ausgerüstete Beschichtungsanlage und ein Verfahren zum Chargieren von Werkstücken.

Es sind verschiedene Arten von Beschichtungsanlagen bekannt zum Aufbringen von Oberflächenbeschichtungen auf Werkstücken, insbesondere auf Werkzeuge. Bspw. in PVD- oder CVD-Beschichtungsanlagen werden Beschichtungsmaterialien auf Werkstücken abgeschieden.

Innerhalb der Beschichtungsanlage, d. h. bspw. bei Vakuum-Beschichtungsanlagen innerhalb der Vakuum-Kammer, werden die Werkstücke angeordnet und so positioniert, dass sie dem Beschichtungsvorgang ausgesetzt sind. Eine Chargiervorrichtung dient dazu, die Werkstücke geeignet zu halten und zu positionieren sowie meist auch innerhalb des Beschichtungsraumes zu bewegen, so dass die Werkstücke dem Beschichtungsvorgang in möglichst günstiger Weise ausgesetzt sind, insbesondere um eine möglichst gleichmäßige Beschichtung zu ermöglichen.

Zur Anordnung der Werkstücke sind Drehtische bekannt, insbesondere solche, auf denen wiederum planetar drehende Drehteller mit Haltern für Werkstücke angeordnet sind.

In der industriellen Beschichtung wird jeweils eine Anzahl von Werkstücken chargiert, nämlich in der Chargiervorrichtung angeordnet und dann das Beschichtungsverfahren durchgeführt. Die beschichteten Werkzeuge werden danach entnommen. Eine einfache Handhabung, die das Einsetzen und Entnehmen der Werkstücke auf besonders einfach Weise ermöglicht, ist somit vorteilhaft. Gleichzeitig sollten die Werkstücke aber während der Beschichtung möglichst in definierter Lage gehalten werden. Sofern bei dem Beschichtungsverfahren eine Substratvorspannung (Bias) verwendet wird, ist zudem eine elektrische Kontaktierung der Werkstücke erforderlich.

Ein Typ von Werkstücken, bei denen eine Beschichtung insbesondere mit Verschleißschutzschichten vorteilhaft ist, sind zylindrische Werkstücke oder solche, die zumindest einen zylindrischen Schaft aufweisen, insbesondere Werkzeuge, bspw. rotierende Werkzeuge wie Bohrer, Fräser, etc.

Die US 2008/0305267 A1 offenbart eine Vorrichtung und ein Verfahren zur Beschichtung einer Anzahl von Substraten. Ein drehbarer Träger ist in einer Vakuumkammer mit Sputter-Targets angeordnet. Paletten sind auf dem Träger innerhalb der Vakuumkammer angeordnet, die jeweils übereinander an einer Achse angeordnete Scheiben aufweisen. Jede Scheibe umfasst eine Mehrzahl von Bohrlöchern entlang der Peripherie mit zylindrischer Berandung. Eine Mehrzahl von Spindeln mit zylindrischer Wandung sind dazu ausgebildet, in den Bohrlöchern getragen zu werden, wobei die Wandung der Spindel gerändelt sein kann. Während der Beschichtung werden die Scheiben und der Träger um ihre jeweiligen Achsen gedreht, so dass die Spindeln in den Bohrlöchern zwei Zentripetalkräften ausgesetzt sind, so dass die Spindeln in den Löchern rollen.

Die DE 39 33 911 A1 offenbart eine Substrathalterung zum Einsatz für Beschichtungen von geometrisch komplizierten Substratkörpern unter Vakuum, wobei die Substrate eine Eigenrotation ausführen sollen. Ein Planet innerhalb eines Planetensystems weist zwei parallele Wellen auf, an denen zentrisch Ringe mit Bohrungen gleicher Teilung montiert sind. Substrathalterungen mit zu beschichtenden Substraten, bspw. Spiralbohrern, sind in den Bohrungen aufgenommen. Bei Drehung der Wellen bewegen sich die Ringe mit den Bohrungen, an deren Wandung sich die Substrathalterungen abstützen, so dass diese an der Bohrungswand abrollen und sich dabei drehen.

Die DE 697 09 306 T2 offenbart eine modulare Halterung zur gleichzeitigen Beschichtung zahlreicher Werkstücke. An einem zentralen Schaft sind zwei voneinander beabstandete Stützplatten angeschweißt, die eine Vielzahl von Buchsen aufweisen, die durch hohle, zylinderförmige Muffenglieder gebildet sind. Spindelanordnungen mit einem Schaftabschnitt sind in den Muffen aufgenommen und verfügen über Rückhaltevorrichtungen mit einem becherförmigen Glied zur Aufnahme einer Vielzahl von zu beschichtenden Werkstücken, bspw. von Schaufeln oder Blättern. Während des Beschichtungsvorgangs wird die Halterung durch ein Antriebssystem um ihre Längsachse gedreht, so dass durch die Schwerkraft und die Reibung zwischen den Buchsen und Spindelanordnungen jedes Werkstück gedreht wird.

Die DE 20 2004 009 256 U1 beschreibt eine Werkstückträgervorrichtung zum Halten von Werkstücken, insbesondere während einer Oberflächenbehandlung, bspw. Beschichtung. Die Werkstückträgervorrichtung umfasst einen Substrattisch mit einem um eine Planetenachse drehbaren Planetenelement. Ein Planetenelement weist Bohrungen auf, in denen hülsenförmig ausgebildete Mondelemente drehbar gelagert sind.

In der DE 10 2013 007 452 ist eine Halterung für Bohrer in einer Vakuumbeschichtungsanlage offenbart. Durch Stifte, die in Spannnuten der Bohrer eingreifen, werden diese an einer Aufnahmehülse befestigt.

Die JP H02 17552 U beschreibt eine Vorrichtung sowie ein Verfahren zur Beschichtung von Werkzeugen mittels PVD. Dazu ist in einer Vakuumkammer ein rotierbarer Ständer vorgesehen, in dessen Oberfläche O-förmige Halter angebracht sind, in denen die zu beschichtenden Werkzeuge horizontal aufgenommen sind.

Die US 6 866 889 B1 beschreibt einen Halter zur PVD- Beschichtung von Bohrern. Der Halter weist Außenwände mit Bohrungen und parallel zu jeder Außenwand eine Innenwand mit Bohrungen auf, die deckungsgleich mit den Bohrungen der Außenwand angeordnet sind.

Die US 2013/264169 A1 offenbart eine Halterung zur PVD-Beschichtung von Bohrern. Die Halterung ist aus drei parallel zueinander angeordneten Platten gebildet, die zahlreiche Öffnungen für jeweils einen Bohrer aufweisen.

Es ist Aufgabe der Erfindung, eine Chargiervorrichtung, eine hiermit ausgerüstete Beschichtungsanlage sowie ein Verfahren zum Chargieren von Werkstücken in einer Beschichtungsanlage vorzuschlagen, bei denen eine flexible Chargierung mit unterschiedlichen Werkstücken besonders einfach möglich ist.

Die Aufgabe wird gelöst durch eine Chargiervorrichtung nach Anspruch 1, eine Beschichtungsanlage nach Anspruch 13 und ein Verfahren nach Anspruch 15. Abhängige Ansprüche beziehen sich auf vorteilhafte Ausführungsformen der Erfindung.

Die erfindungsgemäße Changiervorrichtung umfasst mindestens einen aufrecht angeordneten Ständer. Der Ständer weist eine Außenfläche, d.h. nach Außen weisende Front auf. Die Außenfläche kann in Richtung einer Kammerwandung weisen, bevorzugt in Richtung einer Quelle von Beschichtungsmaterial, wie bspw. einer Magnetron-Kathode.

In der entsprechend der aufrechten Stellung des Ständers bevorzugt mindestens im Wesentlichen (d. h. bspw. +/- 15 °) senkrecht ausgerichteten Außenfläche sind eine Anzahl von übereinander angeordneten Öffnungen vorgesehen. Eine Anzahl von Einsatzhülsen sind zur Aufnahme in den Öffnungen vorgesehen. Die Einsatzhülsen weisen jeweils einen Schaft und eine Haltestruktur sowie eine Bohrung zur Aufnahme eines Werkstücks auf. Dabei dient die Bohrung bevorzugt zum Einstecken eines zylindrischen Werkstücks bzw. eines zylindrischen Schaftes eines Werkstücks. Die Bohrung muss nicht rund sein, dies ist aber bevorzugt. Die Bohrung ist weiter bevorzugt zylindrisch. Besonders bevorzugt wird ein Schaft eines Werkstücks in der Bohrung passend, aber ohne Hinterschneidung aufgenommen, so dass er einfach einsteckbar und ebenso wieder entnehmbar ist.

Der Ständer ist aufrecht angeordnet, d. h. entweder vollständig senkrecht oder ggfs. auch leicht gegenüber der Vertikalen geneigt, und kann auf einer Drehvorrichtung, bspw. auf einem Drehteller, so angebracht sein, dass er während des Beschichtungsvorgangs bewegt wird. Eine Drehachse ist dabei bevorzugt vertikal angeordnet und damit mindestens im Wesentlichen parallel zu den Haltern und deren Außenflächen.

Der Schaft der Einsatzhülsen ist dazu vorgesehen, durch die jeweilige Öffnung hindurch in den Ständer eingestreckt zu werden. Hierzu ist die zugehörige Öffnung von ihrer Form und ihren Abmessungen her so auf die Größe der dort einzusteckenden Einsatzhülse angepasst, dass der Schaft der Einsatzhülse hindurch gesteckt werden kann, so dass die Haltestruktur der Einsatzhülse mit der Öffnung einen haltenden Eingriff bilden kann.

Die Haltestruktur einer Einsatzhülse und die zugehörige Öffnung sind von Form und Abmessungen relativ zueinander so ausgebildet, dass nach dem Einstecken des Schafts ein haltender Eingriff zwischen einer Öffnung und einer in sie eingesteckten Einsatzhülse resultiert.

Bevorzugt sind die Einsatzhülsen fixierbar, so dass sie zum Betrieb der Beschichtungsanlage in den Öffnungen fixiert sind. Die Position der Einsatzhülsen ist dann bevorzugt gegenüber dem Halter fest und somit unbeweglich. Durch eine Rotation des Halters, bspw. auf einem Drehteller, kann eine ausreichend gleichmäßige Beschichtung erzielt werden.

Eine erfindungsgemäß ausgebildet Chargiervorrichtung ist durch die Möglichkeit, Werkstücke in der Bohrung aufzunehmen, besonders gut dazu geeignet, diese während der Beschichtung zu halten. Bevorzugt ist die Bohrung von Form und Abmessungen passend zum Werkstück bzw. zum Werkstückschaft ausgebildet. Bei der bevorzugten Verwendung von Ständern und Einsatzhülsen aus Metall kann zudem eine gute elektrische Kontaktierung gewährleistet werden.

Dabei kann der Ständer der Chargiervorrichtung besonders einfach und kostengünstig aufgebaut sein, bspw. als Blechteil, d.h. aus flachem Material, das bspw. in gewünschter Form gebogen ist und in dem die Öffnungen bspw. durch Stanzen oder Laser-Schneiden gebildet sind. Die Öffnungen können in dem Blechmaterial gebildet sein, so dass die Haltestrukturen einen Eingriff mit den Kanten bzw. Rändern der Öffnungen bilden können.

Mindestens eine Mehrzahl der Öffnungen, bevorzugt alle Öffnungen, können gleiche Form und Abmessungen aufweisen. Von den Einsatzhülsen können hingegen verschiedene Typen verwendet werden, bevorzugt mit gleicher äußerer Form, aber mit unterschiedlichen, jeweils an die Anforderungen der Werkstücke angepassten Bohrungen. Somit bilden die Einsatzhülsen eine Art Adapter zur Aufnahme unterschiedlicher Werkstücke am Ständer. Hierdurch ist eine besonders flexible Bestückung und schnelle Anpassbarkeit der Chargiervorrichtung auf unterschiedliche Chargen leicht möglich.

Es können Einsatzhülsen mit Bohrungen unterschiedlichen Durchmessers vorgesehen sein. Dabei sind die Bohrungen bevorzugt nicht durchgängig, sondern weisen eine begrenzte Bohrungstiefe auf. Je nach Länge der Werkstücke können verschiedene Einsatzhülsen mit unterschiedlichen Bohrungstiefen verwendet werden.

Die Einsatzhülsen können besonders einfach und damit auch kostengünstig ausgebildet sein. Bevorzugt ist eine zylindrische Form mindestens der Schäfte der Einsatzhülsen. Während vorliegend unter einer zylindrischen Form generell eine langgestreckte Form gleichbleibenden Querschnitts verstanden wird, was bspw. für die Einsatzhülsen Mehrkantformen etc. einschließt, wird besonders eine kreiszylindrische Form der Schäfte der Einsatzhülsen bevorzugt, da sich diese Form für eine einfache und kostengünstige Herstellung ebenso wie für eine einfach Handhabung besonders eignet. Generell wird für die Einsatzhülsen eine mindestens im Wesentlichen rotationssymmetrische Form bevorzugt, was die Herstellung als Drehteil besonders einfach und kostengünstig macht.

Somit ist es möglich, die Bestandteile der Chargiervorrichtung einfach und kostengünstig herzustellen. Insbesondere die bevorzugte Kombination des Ständers als Blechteil und der Einsatzhülsen als Drehteil ermöglicht eine einfache und kostengünstige Herstellung. Gemäß einer Weiterbildung der Erfindung sind die Haltestrukturen der Einsatzhülsen so ausgebildet, dass sie einen Anschlagsbereich umfassen, der nicht durch die Öffnungen hindurch steckbar ist. Die Haltestrukturen können bevorzugt jeweils an einem Ende der Hülsen angeordnet sein. Insbesondere kann es sich bei dem Anschlagbereich um einen Kragen mit größerem Durchmesser handeln, der nicht durch die Öffnung hindurch passt. Weiter bevorzugt können die Haltestrukturen am Umfang der Einsatzhülsen Vertiefungen zum Eingriff mit den Rändern der Öffnungen aufweisen bspw. als mindestens teilweise umlaufende, besonders bevorzugt vollständig umlaufende Nuten.

Gemäß einer Weiterbildung der Erfindung sind die Öffnungen so ausgebildet, dass sie jeweils einen ersten, weiteren Bereich und einen zweiten, engeren Bereich aufweisen. Der erste Bereich kann zum Durchstecken der Schäfte der Einsatzhülsen dienen, während die Haltestrukturen der Einsatzhülsen danach mit der Kante des zweiten Bereichs einen Eingriff bilden. Bevorzugt ist der erste, weitere Bereich über dem zweiten, engeren Bereich angeordnet, so dass die Einsatzhülse durch die Schwerkraft in Richtung des zweiten, engeren Bereichs beaufschlagt wird. Die beiden Bereiche können bspw. als runde Bohrungen mit verschiedenen Durchmessern ausgebildet sein.

Gemäß einer Weiterbildung der Erfindung ist vorgesehen, dass die Öffnungen und die Haltestrukturen so ausgebildet sind, dass die Einsatzhülsen gegenüber dem Ständer um einen Anstellwinkel kippbar sind. Hierunter wird verstanden, dass die Einsatzhülsen mindestens in der Eingriffslage hinsichtlich Ihres Winkels relativ zum Halter zunächst nicht fixiert sind. Der Anstellwinkel kann dabei bspw. gebildet werden zwischen der Längsmittelachse, der Einsatzhülse und der auf der Öffnung senkrechten Richtung. Bevorzugt können die Öffnungen und die Haltestrukturen so ausgebildet sein, dass die Einsatzhülsen in einer Einführlage senkrecht zur Außenfläche des Ständers durch die Öffnungen führbar sind und die Einsatzhülsen im eingeführten Zustand um einen Anstellwinkel gegenüber der bevorzugt horizontalen Einführlage kippbar sind.

Bevorzugt sind die Einsatzhülsen und der Halter mit den Öffnungen so angeordnet, dass die Einsatzhülsen in der Eingriffslage an dem Halter so aufgenommen sind, dass die Bohrungen mindestens um einen geringen Betrag schräg nach oben weisen. Dann ist eine Aufnahme und gute Halterung der Werkstücke durch einfaches Einstecken in die Bohrungen möglich, wobei aufgrund der schrägen Anordnung die Schwerkraft gewährleistet, dass die Werkstücke nicht aus den Bohrungen herausfallen können.

Bevorzugt ist die Anordnung so, dass der Halter mindestens im Wesentlichen senkrecht angeordnet ist und die hiermit im Eingriff befindlichen Einsatzhülsen einen Winkel von bspw. 3 - 60 Grad mit der Horizontalen, bevorzugt weniger als 45 Grad, besonders bevorzugt 5 - 30 Grad mit der Horizontalen bilden. Diese Lage der Einsatzhülsen kann sich dadurch einstellen, dass deren Schäfte aufgrund Ihres Gewichts und ihrer Abmessungen die Einsatzhülsen schräg nach unten verkippen, bis diese durch den Eingriff zwischen den Haltestrukturen und den Öffnungen in der gewünschten Lage mit schräg nach oben weisenden Bohrungen gehalten sind. Bevorzugt können die Einsatzhülsen nach dem Einsetzen in geeigneter Lage am Halter verriegelt werden, bspw. durch ein Riegelblech, insbesondere mit kammförmiger Struktur.

Gemäß einer Weiterbildung der Erfindung sind die am Ständer gebildeten Öffnungen mindestens zum Teil zueinander versetzt und/oder verdreht angeordnet. Insbesondere können direkt übereinander angeordnete Öffnungen jeweils zueinander einen Versatz oder eine Verdrehung aufweisen. Hiermit kann erreicht werden, dass die Einsatzhülsen darin nicht parallel angeordnet werden, sondern in voneinander abweichende Richtungen weisen. Eine solche Anordnung kann für eine gleichmäßige Beschichtung vorteilhaft sein. Dementsprechend ist es bevorzugt, dass am Ständer eine Anordnung von Öffnungen übereinander so gebildet ist, dass bei bestehendem Eingriff mit darin aufgenommenen Einsatzhülsen diese unter mindestens zwei verschiedenen Winkeln zum Ständer angeordnet sind.

Während eine solche versetzte Anordnung erreicht werden kann, bspw. durch entsprechend gebogene Formen des Halters, ist es bevorzugt, die Öffnungen verdreht zueinander anzuordnen. In diesem Fall haben die Öffnungen keine runde Form, sondern weisen bspw. wie oben bereits erläutert, einen ersten, weiteren Bereich und einen zweiten, engeren Bereich auf. Bspw. übereinander angeordnete Öffnungen können dann jeweils zueinander um einen gewissen Betrag verdreht sein, bspw. 5 - 45 Grad, so dass schräg darin aufgenommene Einsatzhülsen entsprechend unterschiedliche Winkel zum Halter bilden.

Bevorzugt ist eine Anzahl von Ständern nebeneinander angeordnet. Während verschiedene Ständer planetar zueinander drehbar sein können, eignet sich die erfindungsgemäße Anordnung besonders für eine Außenchargierung, bei der Halter aufrecht nebeneinander um den Umfang herum angeordnet sind, von denen die in den Einsatzhülsen aufgenommenen Werkstücke jeweils nach Außen hervorstehen.

Die Erfindung bezieht sich auch auf eine Beschichtungsanlage mit einer Chargiervorrichtung wie vorstehend beschrieben. Die Beschichtungsanlage umfasst eine Beschichtungskammer, d. h. einen abgeschlossenen Raum, in dem die Beschichtung aufgebracht werden kann. Der oder die Halter werden innerhalb der Beschichtungskammer angeordnet. Durch Beschichtungsmittel wird die Beschichtung auf die in der Chargiervorrichtung gehaltenen Werkstücke aufgebracht. Besonders bevorzugt ist die Beschichtungskammer als Vakuumkammer ausgebildet und die Beschichtungsmittel dienen dazu, ein Plasma zu erzeugen, aus dem Bestandteile als Beschichtung auf den Werkstücken abgeschieden werden.

Beim erfindungsgemäßen Verfahren zum Chargieren von Werkstücken in einer Beschichtungsanlage werden Werkstücke in die Bohrungen der oben beschriebenen Einsatzhülsen eingesteckt und die Einsatzhülsen in Öffnungen des Ständers eingesteckt. Dabei ist die Reihenfolge dieser Schritte nicht maßgeblich, sondern es ist sowohl möglich, dass zunächst die Werkstücke in die Einsatzhülsen und danach die Einsatzhülsen in die Öffnungen eingesteckt werden als auch umgekehrt.

Nachfolgend wir eine Ausführungsform der Erfindung anhand von Zeichnungen näher beschrieben. Dabei zeigen:
- Fig. 1: eine perspektivische, teilweise schematische Ansicht einer Beschichtungsanlage mit einer Chargiervorrichtung;
- Fig. 2a, 2b: perspektivische Ansichten von Teilen der Chargiervorrichtung aus Fig. 1;
- Fig. 3: in perspektivischer Ansicht verschiedene Einsatzhülsen der Chargiervorrichtung aus Fig. 1;
- Fig. 4: ein Teil der Chargiervorrichtung in Draufsicht;
- Fig. 5: eine Darstellung des Teils aus Fig. 4 im Querschnitt;
- Fig. 6a - 6d: eine Darstellung des Teils der Chargiervorrichtung aus Fig. 4, Fig. 5 in Seitenansicht in verschiedenen Positionen.

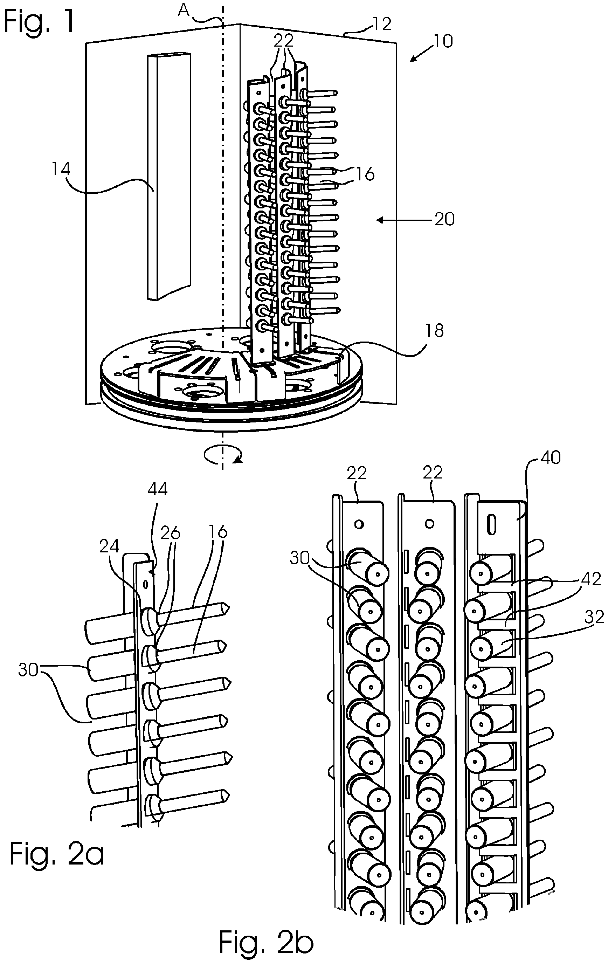

In Fig. 1 ist - teilweise schematisch - eine Beschichtungsanlage 10 dargestellt. Bspw. kann es sich um eine PVD-Beschichtungsanlage handeln mit einer Vakuumkammer 12, in der mehrere Magnetron-Kathoden 14 (von denen in Fig. 1 nur eine beispielhaft gezeigt ist) angeordnet sind, mit denen im Inneren der Vakuumkammer 12 ein Plasma erzeugt werden kann, dessen Bestandteile zur Bildung einer Oberflächenbeschichtung auf Werkstücken 16 abgeschieden werden.

Die Werkstücke 16 sind innerhalb der Kammer 12 angeordnet an einer Chargiervorrichtung 20. Diese ist auf einem um eine senkrechte Drehachse A drehbaren Drehteller 18 positioniert und umfasst eine Anzahl von senkrecht stehenden Haltern 22, die nebeneinander angebracht sind. Während aus Gründen der Übersichtlichkeit in Fig. 1 nur drei Halter 22 nebeneinander angeordnet gezeigt sind, umfasst die Chargiervorrichtung 20 eine größere Anzahl von bspw. 18 solcher Halter 22, die nebeneinander insgesamt kreisförmig auf dem Drehteller 18 angeordnet sind. Die Chargiervorrichtung 20 bildet dabei eine Außenchargierung, bei der die Werkstücke 16 jeweils nach außen weisend an dem Halter 22 feststehend angeordnet sind.

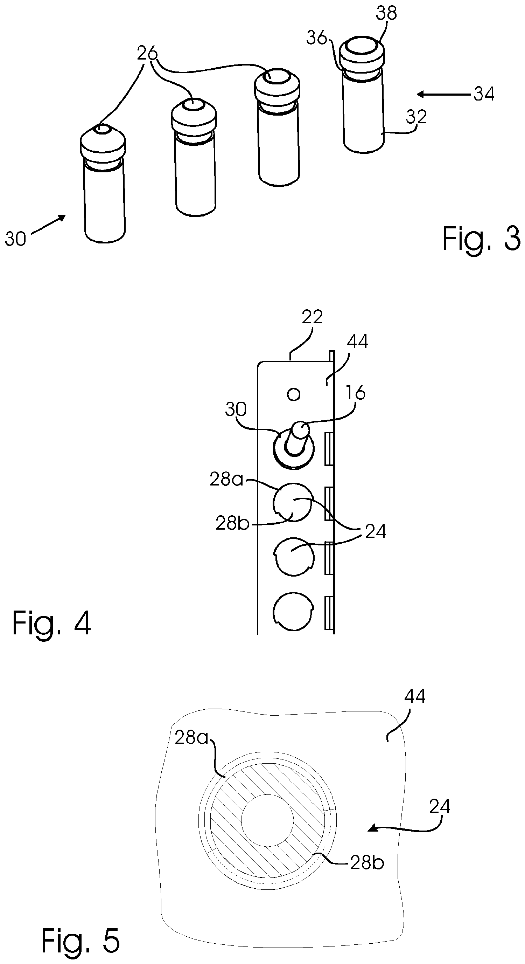

Jeder der Halter 22 ist wie bspw. aus Fig. 4 ersichtlich ein Blechbiegeteil aus einem winkelförmig gebogenen Blech. In einer planen, aufrechten, nach Außen gerichteten Fläche 44 jedes Halters 22 sind übereinander eine Anzahl von Öffnungen 24 ausgeschnitten.

Wie bspw. in Fig. 2a, 2b dargestellt, sind bei Bestückung des Halters 22 in den Öffnungen 24 Einsatzhülsen 30 eingesteckt. Die Einsatzhülsen 30 weisen jeweils eine mittige Bohrung 26 auf. In die Bohrungen 26 sind die Werkstücke 16 eingesteckt. Dabei weisen die Bohrungen 26 jeweils eine begrenzte Bohrungstiefe auf, so dass die Werkstücke 16 darin nur bis zur Bohrungstiefe eingesteckt werden können und somit eine definierte Lage einnehmen.

Bei den Werkstücken 16 handelt es sich im dargestellten Beispiel um stiftförmige, zylindrische Teile, wie bspw. Bohrer, Frässtifte, etc.. Es können aber auch Werkstücke anderer Form, die einen zylindrischen Schaft aufweisen, in die Bohrungen 26 eingesteckt werden. Wie in Fig. 3 dargestellt, dienen verschiedene Typen von Einsatzhülsen 30, die identische äußere Abmessungen, aber Bohrungen 26 von unterschiedlichem Durchmesser aufweisen, zur Aufnahme von Werkstücken 16 verschiedenen Schaftdurchmessers. Bspw. können bei einem Außendurchmesser der Einsatzhülsen 30 von 14mm Bohrungen 26 mit Durchmessern von 6 - 12mm vorgesehen sein, um Werkstückschäfte von jeweils passendem bzw. geringfügig kleinerem Durchmesser darin aufzunehmen. Dabei werden die Werkstücke 16 lediglich lose in die Bohrungen 26 eingesteckt, ohne dass eine weitere Befestigung oder Verriegelung zwingend notwendig wäre.

In alternativen Ausführungen können Einsatzhülsen 30 mit Bohrungen unterschiedlichen Durchmessers vorgesehen sein. Die verschiedenen Durchmesser der Bohrungen werden dabei sinnvollerweise abhängig vom jeweils verwendeten Außendurchmesser der Einsatzhülsen 30 zu wählen sein. Bspw. können in einer alternativen Ausführung Halter 22 vorgesehen sein, bei denen eine größere Anzahl von Öffnungen 24 mit geringerem Durchmesser vorgesehen ist. In diese Öffnungen 24 können dann bspw. Einsatzhülsen 30 eines Außendurchmessers von 10mm eingesetzt werden, wobei die unterschiedlichen Einsatzhülsen 30 Bohrungsdurchmesser von bspw. 2 - 8 mm aufweisen.

Generell können die Bohrungsdurchmesser somit in Abhängigkeit vom Außendurchmesser der Einsatzhülsen gewählt werden und bspw. im Berech von 20 - 85 % des Außendurchmessers liegen.

Die verschiedenen Einsatzhülsen 30 mit unterschiedlichem Bohrungsdurchmesser dienen aufgrund ihrer identischen äußeren Abmessungen als Adapter, um verschiedene Werkstücke 16 mit unterschiedlichem Schaftdurchmesser an demselben Halter 22 der Chargiervorrichtung 20 anzuordnen. Je nach Schaftlänge der Werkstücke 16 kann auch die Bohrungstiefe angepasst sein.

Jede der Einsatzhülsen 30 weist einen außenkreiszylindrischen Schaft 32 und einen Kopf 34 mit einer umlaufenden Nut 36 und einem Flansch 38 auf. Die Einsatzhülsen 30 sind rotationssymmetrisch, so dass sie aus einem Stück als Drehteile hergestellt werden können. Durch die Verwendung von Metall, bspw. Stahl, insbesondere rostfreiem Stahl, kann über den ebenfalls metallischen Halter 22 auch eine elektrische Kontaktierung der eingesteckten Werkstücke 16 erfolgen.

In Fig. 4, Fig. 5 ist die Form der Öffnungen 24 dargestellt. Diese umfassen jeweils einen ersten, weiteren Bereich 28a und einen zweiten, engeren Bereich 28b. Im gezeigten Beispiel sind die Bereiche 28a, 28b jeweils etwa halbkreisförmig, wobei der weitere Bereich 28a mit größerem Durchmesser oberhalb und der engere Bereich 28b mit kleinerem Durchmesser unterhalb angeordnet ist.

Die Teilung der Öffnungen 24 in die beiden Bereiche 28a, 28b verläuft dabei nicht exakt senkrecht, sondern ist gegenüber der Waagerechten jeweils leicht um einen Winkel von ca. 15 Grad gedreht angeordnet. Dabei sind untereinander angeordnete Öffnungen 24 jeweils gegensätzlich gedreht, so dass sie zueinander einen Drehwinkel von ca. 30 Grad aufweisen. Wie nachfolgend gezeigt wird, dient dies dazu, die Einsatzhülsen 30 am Halter 22 unter verschiedenen Winkeln versetzt zueinander anzuordnen.

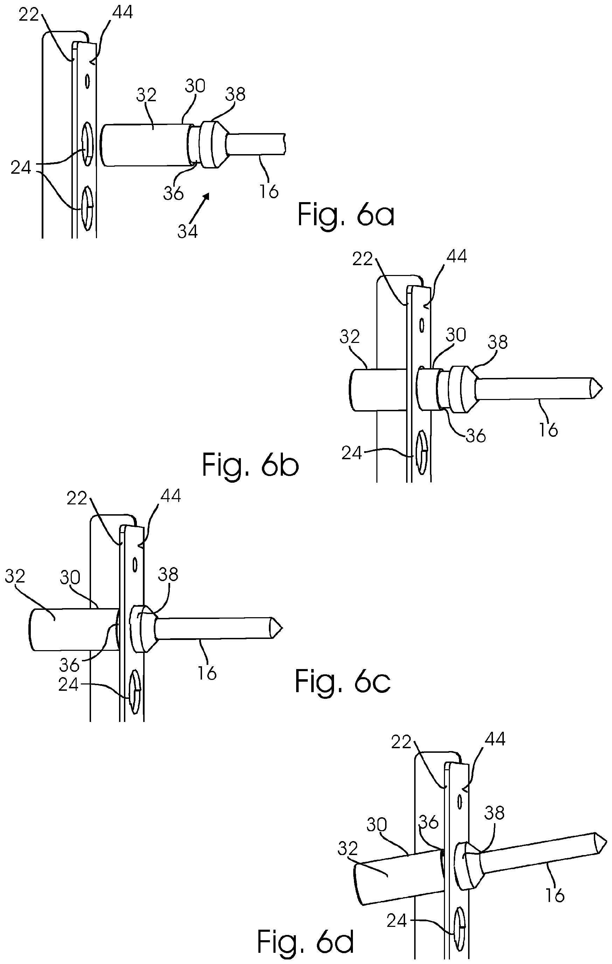

Die Einsatzhülsen 30 werden wie nachfolgend im Hinblick auf Fig. 6a - 6d beschrieben in den Halter 22 eingesetzt. Dabei wird zunächst der Schaft 32 einer Hülse 30 horizontal und damit rechtwinklig zur aufrechten Außenfläche 44 des Halters 22 durch die jeweilige Öffnung 24 hindurch gesteckt (Fig. 6b). Die Öffnung 24, und insbesondere deren weiterer oberer Bereich 28a sind so bemessen, dass der Schaft 32 mit etwas Spiel leicht hindurch gesteckt werden kann.

Der Kopf 34 der Einsatzhülsen 30 bildet eine Haltestruktur zum Fixieren der Einsatzhülse 30 am Halter 22 aus. Der Flansch 38 ist dabei so bemessen, dass er aufgrund des größeren Außendurchmessers nicht durch die Öffnung 24 hindurch gesteckt werden kann und somit als Anschlag beim Einstecken dient (Fig. 6c). In dieser Position kann die umlaufende Nut 36 in Eingriff mit dem Rand der Öffnung 24, insbesondere mit dem Rand des unteren Bereichs 28b gebracht werden.

Dabei ist der Durchmesser der Einsatzhülse 30 im Bereich der Nut 36 kleiner als der Durchmesser der Öffnung 24, so dass sie mit Spiel darin aufgenommen ist. Die Einsatzhülse 30 ist hierdurch in ihrer Ausrichtung, d.h. dem Anstellwinkel relativ zum Halter 22 nicht fixiert, sondern kippbar. Wie in Fig. 6d gezeigt, wird die Einsatzhülse 30 gegenüber der Horizontalen nach dem Einführen um einen Winkelbetrag von bspw. etwa 10 Grad gekippt, so dass die Bohrung 26 schräg leicht nach oben zeigt. Unter diesem Anstellwinkel kann das eingesetzte Werkstück 16 nicht aus der Einsatzhülse 30 herausfallen.

Durch die oben beschriebene gegenseitig in Drehrichtung versetzte Anordnung untereinander angeordneter Öffnungen 24 (Fig. 4) nehmen die Einsatzhülsen 30, wie insbesondere aus Fig. 2b ersichtlich, zueinander versetzte Lagen ein. Die Einsatzhülsen 30 stehen von dem Halter 22 nach Innen vor, und die darin aufgenommenen Werkstücke 16 stehen von der Außenfläche 44 des Halters 22 nach außen vor, unter dem o.g. geringfügigen Anstellwinkel zur Horizontalen. Dabei erstrecken sie sich jeweils nicht exakt radial, sondern weisen in gegeneinander versetzte Richtungen. Somit sind in der bestückten Chargiervorrichtung (Fig. 2a) die Werkstücke 16 an einem Halters 22 nicht parallel zueinander, sondern versetzt angeordnet.

Die eingesetzten Einsatzhülsen 30 werden am Halter 22 durch ein Riegelblech 40 (Fig. 2b) verriegelt. Das Riegelblech 40 weist eine kammförmige Struktur mit einer Anzahl von parallelen Stegen 42 auf. Das Riegelblech 40 wird am Halter 22 so befestigt, dass die Stege 42 jeweils an den Schäften 32 der Einsatzhülsen 30 anliegen und diese in der gekippten Lage (siehe bspw. Fig. 6d) verriegeln. So sind die Einsatzhülsen 30 und die darin eingesteckten Werkstücke 16 ortsfest und gegenüber dem Halter 22 unbeweglich festgelegt.

Die Beschichtungsanlage 10 aus Fig. 1 kann somit zur Beschichtung von verschiedenen Werkstücken 16 genutzt werden, indem zunächst zu den jeweiligen Werkstücken 16 passende Einsatzhülsen 30 zusammengestellt werden. Die Einsatzhülsen 30 werden dann wie beschrieben in die Öffnungen 24 an den Haltern 22 eingesteckt und mittels des Riegelblechs 40 verriegelt. Damit ist die Chargiervorrichtung 20 vorbereitet und die Werkstücke 16 können eingesteckt werden. Alternativ können auch die Einsatzhülsen 30 mit bereits eingesteckten Werkstücken 16 in die Öffnungen 24 eingesetzt werden.

Nach der so erfolgten Chargierung kann die Kammer 12 geschlossen und mit dem Beschichtungsvorgang begonnen werden. Dabei dreht sich der Drehteller 18, so dass die außen chargierten Werkstücke jeweils vor der Kathode 14 vorbeigeführt werden, so dass sich die gewünschte Beschichtung ablagert. Nach erfolgter Beschichtung können die Werkstücke 16 durch einfaches Herausziehen aus den Einsatzhülsen 30 entnommen werden.

Für nachfolgende Beschichtungsvorgänge mit gleicher Charge an Werkstücken 16 bzw. deren Durchmessern kann die Chargiervorrichtung 20 unverändert verwendet werden. Im Fall einer anderen Chargierung, d. h. von Werkstücken 16 mit unterschiedlichem Durchmesser, können einzelne oder alle der Einsatzhülsen 30 entsprechend den benötigten Maßen ausgetauscht werden.

## Patentansprüche

1. Chargiervorrichtung für Werkstücke (16) in einer Beschichtungsanlage (10), mit
- mindestens einem aufrecht angeordneten Ständer (22) mit einer nach Außen weisenden Fläche (44), in der eine Anzahl von übereinander angeordneten Öffnungen (24) gebildet ist,
- und einer Anzahl von Einsatzhülsen (30) zur Aufnahme in den Öffnungen (24), wobei die Einsatzhülsen (30) jeweils einen Schaft (32) und eine Haltestruktur (34) aufweisen sowie eine Bohrung (26) zur Aufnahme eines Werkstücks (16),
- wobei die Öffnungen (24) und die Schäfte (32) der Einsatzhülsen (30) so ausgebildet sind, dass die Einsatzhülsen (30) in die Öffnungen (24) einführbar sind,
- und wobei die Öffnungen (24) und die Haltestrukturen (34) so ausgebildet sind, dass sich ein haltender Eingriff zwischen den Einsatzhülsen (30) und den Öffnungen (24) ergibt.

2. Chargiervorrichtung nach Anspruch 1, bei der
- die Haltestrukturen (34) einen Anschlag (38) umfassen, der so ausgebildet ist, dass er nicht durch die Öffnungen (24) hindurch steckbar ist.

3. Chargiervorrichtung nach einem der vorangehenden Ansprüche, bei der
- die Haltestrukturen (34) am Umfang der Einsatzhülsen (30) Vertiefungen (36) zum Eingriff mit den Rändern der Öffnungen (24) aufweisen.

4. Chargiervorrichtung nach einem der vorangehenden Ansprüche, bei der
- die Öffnungen (24) einen ersten, weiteren Bereich (28a) und einen zweiten, engeren Bereich (28b) aufweisen,
- wobei die Haltestrukturen (34) einen Eingriff mit der Kante des zweiten Bereichs (28b) bilden.

5. Chargiervorrichtung nach einem der vorangehenden Ansprüche, bei der
- die Öffnungen (24) und die Haltestrukturen (34) so ausgebildet sind, dass die Einsatzhülsen (30) in einer Einführlage senkrecht zur Außenfläche (44) des Ständers (22) durch die Öffnungen (24) führbar sind und die Einsatzhülsen (30) im eingeführten Zustand um einen Anstellwinkel gegenüber der Einführlage kippbar sind.

6. Chargiervorrichtung nach einem der vorangehenden Ansprüche, bei der
- die Einsatzhülsen (30) in den Öffnungen (24) gegenüber dem Ständer (22) fixiert sind.

7. Chargiervorrichtung nach einem der vorangehenden Ansprüche, bei der
- die Einsatzhülsen (30) so in den Halter (22) aufgenommen sind, dass die Bohrungen (26) schräg nach oben angeordnet sind.

8. Chargiervorrichtung nach einem der vorangehenden Ansprüche, bei der
- eine Mehrzahl von Öffnungen (24) gleiche Form und Abmessung aufweist.

9. Chargiervorrichtung nach einem der vorangehenden Ansprüche, bei der
- am Ständer (22) Öffnungen (24) versetzt und/ oder verdreht zueinander angeordnet sind.

10. Chargiervorrichtung nach einem der vorangehenden Ansprüche, bei der
- am Ständer (22) eine Anordnung von Öffnungen (24) übereinander so gebildet ist, dass bei bestehendem Eingriff mit darin aufgenommenen Einsatzhülsen (30) diese unter mindestens zwei verschiedenen Winkeln zum Ständer (22) angeordnet sind.

11. Chargiervorrichtung nach einem der vorangehenden Ansprüche, bei der
- der Ständer (22) als Blechteil und die Einsatzhülsten (30) als Drehteil gefertigt sind.

12. Chargiervorrichtung nach einem der vorangehenden Ansprüche, bei der
- eine Vorrichtung (18) zum Drehen des Ständers (22) um eine vertikal angeordnete Drehachse (A) vorgesehen ist.

13. Beschichtungsanlage mit
- einer Beschichtungskammer (12),
- einer Chargiervorrichtung (20) nach einem der vorangehenden Ansprüche innerhalb der Beschichtungskammer (12),
- Beschichtungsmitteln (14) zum Aufbringen einer Beschichtung auf in der Chargiervorrichtung (20) gehaltene Werkstücke (16).

14. Beschichtungsanlage nach Anspruch 13, bei der
- die Beschichtungskammer (12) als Vakuumkammer ausgebildet ist,
- und die Beschichtungsmittel (14) ausgebildet sind, um ein Plasma zu erzeugen.

15. Verfahren zum Chargieren von Werkstücken (16) in einer Beschichtungsanlage (10), bei dem
- Werkstücke (16) in Bohrungen (26) von Einsatzhülsen (30) eingesteckt werden, wobei die Einsatzhülsen (30) jeweils einen Schaft (32) und eine Haltestruktur (34) aufweisen,
- und die Einsatzhülsen (30) in übereinander angeordnete Öffnungen (24) in einer nach Außen weisenden Fläche (44) mindestens eines aufrecht angeordneten Ständers (22) eingesteckt werden, indem die Schäfte (32) durch die Öffnungen (24) hindurch gesteckt werden,
- wobei ein haltender Eingriff zwischen den Haltestrukturen (34) der Einsatzhülsen (30) und den Öffnungen (24) gebildet wird.

## Claims

1. A loading device for workpieces (16) in a coating system (10) with
- at least one stand (22) arranged upright with an outward-facing surface (44) in which a number of openings (24) are arranged above one another
- and a number of insertion sleeves (30) for accommodation in the openings (24), with the insertion sleeves (30) each having a shaft (32) and a retaining structure (34) as well as a borehole (26) to accommodate a workpiece (16),
- wherein the openings (24) and the shafts (32) of the insertion sleeves (30) are designed such that the insertion sleeves (30) are insertable in the openings (24),
- and wherein the openings (24) and retaining structures (34) are designed such that a holding engagement results between the insertion sleeves (30) and the openings (24).

2. A loading device according to claim 1, in which
- the retaining structures (34) include a stop (38) designed so that it cannot be inserted through the openings (24).

3. A loading device according to one of the preceding claims, in which
- the retaining structures (34) have recesses (36) on the circumference of the insertion sleeves (30) for engaging with the edges of the openings (24).

4. A loading device according to one of the preceding claims, in which
- the openings (24) have a first, wider portion (28a) and a second, narrower portion (28b),
- wherein the retaining structures (34) engage with the edge of the second portion (28b).

5. A loading device according to one of the preceding claims, in which
- the openings (24) and the retaining structures (34) are designed so that the insertion sleeves (30) are able to be guided through the openings (24) in an insertion position perpendicular to the outer surface (44) of the stand (22) and the insertion sleeves (30) in the inserted state can be tilted by a working angle with respect to the insertion position.

6. A loading device according to one of the preceding claims, in which
- the insertion sleeves (30) are fixated in the openings (24) with respect to the stand (22).

7. A loading device according to one of the preceding claims, in which
- the insertion sleeves (30) are accommodated in the holder (22) in such a way that the boreholes (26) are arranged at an upward slant.

8. A loading device according to one of the preceding claims, in which
- a plurality of openings (24) have the same shape and dimension.

9. A loading device according to one of the preceding claims, in which
- there are openings (24) on the stand (22) arranged in a staggered and/or skewed manner with respect to one another.

10. A loading device according to one of the preceding claims, in which
- an arrangement of openings (24) above one another on the stand (22) is formed such that with the existing engagement with the insertion sleeves (30) accommodated therein these are arranged with at least two different angles with respect to the stand (22).

11. A loading device according to one of the preceding claims, in which
- the stand (22) is made as a sheet metal part and the insertion sleeves (30) are made as turned parts.

12. A loading device according to one of the preceding claims, in which
- a device (18) is provided for rotating the stand (22) about a vertically situated axis of rotation (A).

13. A coating system with
- a coating chamber (12),
- a loading device (20) according to one of the preceding claims inside the coating chamber (12),
- coating agents (14) for applying a coating to the workpieces (16) held in the loading device (20).

14. A coating system according to claim 13, in which
- the coating chamber (12) is designed as a vacuum chamber,
- and the coating agents (14) are designed to produce a plasma.

15. A method for loading workpieces (16) in a coating system (10), in which
- workpieces (16) are inserted in boreholes (26) of insertion sleeves (30), with the insertion sleeves (30) each having a shaft (32) and a retaining structure (34),
- and the insertion sleeves (30) are inserted in openings (24) arranged above one another in an outward-facing surface (44) of at least one stand (22) which is arranged upright by inserting the shafts (32) through the openings (24),
- wherein a holding engagement is formed between the retaining structures (34) of the insertion sleeves (30) and the openings (24).

## Revendications

1. Dispositif de chargement pour des pièces (16) dans une installation de revêtement (10), comprenant :
- au moins un montant (22) disposé verticalement avec une surface tournée vers l'extérieur (44), dans laquelle est formé un certain nombre d'ouvertures (24) disposées les unes au-dessus des autres,
- et un certain nombre de douilles d'insertion (30) destinées à être reçues dans les ouvertures (24), dans lequel les douilles d'insertion (30) présentent respectivement une tige (32) et une structure de maintien (34) ainsi qu'un alésage (26) destiné à recevoir une pièce (16),
- dans lequel les ouvertures (24) et les tiges (32) des douilles d'insertion (30) sont conçues de telle façon que les douilles d'insertion (30) peuvent être introduites dans les ouvertures (24),
- et dans lequel les ouvertures (24) et les structures de maintien (34) sont conçues de manière à former une prise de retenue entre les douilles d'insertion (30) et les ouvertures (24) .

2. Dispositif de chargement selon la revendication 1, dans lequel
- les structures de maintien (34) comportent une butée (38) conçue de manière à ne pas pouvoir passer à travers les ouvertures (24).

3. Dispositif de chargement selon l'une des revendications précédentes, dans lequel
- les structures de maintien (34) présentent des renfoncements (36) sur le pourtour des douilles d'insertion (30), lesquels sont destinés à venir en prise avec les bords des ouvertures (24).

4. Dispositif de chargement selon l'une des revendications précédentes, dans lequel
- les ouvertures (24) présentent une première région plus large (28a) et une deuxième région plus étroite (28b),
- dans lequel les structures de maintien (34) forment une prise avec le bord de la deuxième région (28b).

5. Dispositif de chargement selon l'une des revendications précédentes, dans lequel
- les ouvertures (24) et les structures de maintien (34) sont conçues de telle façon que les douilles d'insertion (30) peuvent être introduites à travers les ouvertures (24) dans une position d'introduction perpendiculairement à la surface extérieure (44) du montant (22) et que les douilles d'insertion (30) peuvent être basculées dans l'état introduit selon un angle d'inclinaison par rapport à la position d'introduction.

6. Dispositif de chargement selon l'une des revendications précédentes, dans lequel
- les douilles d'insertion (30) sont fixées dans les ouvertures (24) par rapport au montant (22).

7. Dispositif de chargement selon l'une des revendications précédentes, dans lequel
- les douilles d'insertion (30) sont reçues de telle façon dans le support (22), que les alésages (26) sont disposés obliquement vers le haut.

8. Dispositif de chargement selon l'une des revendications précédentes, dans lequel
- une pluralité d'ouvertures (24) présentent une forme et une dimension identique.

9. Dispositif de chargement selon l'une des revendications précédentes, dans lequel
- sur le montant (22), des ouvertures (24) sont décalées et/ou tournées les unes par rapport aux autres.

10. Dispositif de chargement selon l'une des revendications précédentes, dans lequel
- sur le montant (22), un ensemble d'ouvertures (24) superposées est formé de telle façon qu'en présence d'une prise avec des douilles d'insertion (30) reçues dans celles-ci, ces dernières sont disposées selon au moins deux angles différents par rapport au montant (22).

11. Dispositif de chargement selon l'une des revendications précédentes, dans lequel
- le montant (22) est réalisé comme une pièce en tôle et les douilles d'insertion (30) sont réalisées comme un élément rotatif.

12. Dispositif de chargement selon l'une des revendications précédentes, dans lequel
- il est prévu un dispositif (18) destiné à faire tourner le montant (22) autour d'un axe de rotation (A) disposé verticalement.

13. Installation de revêtement comprenant
- une chambre de revêtement (12),
- un dispositif de chargement (20) selon l'une des revendications précédentes à l'intérieur de la chambre de revêtement (12),
- des moyens de revêtement (14) pour l'application d'un revêtement sur des pièces (16) maintenues dans le dispositif de chargement (20).

14. Installation de revêtement selon la revendication 13, dans laquelle
- la chambre de revêtement (12) est conçue comme une chambre à vide,
- et les moyens de revêtement (14) sont conçus pour fabriquer un plasma.

15. Procédé pour le chargement de pièces (16) dans une installation de revêtement (10), comprenant
- l'insertion de pièces (16) dans des alésages (26) de douilles d'insertion (30), les douilles d'insertion (30) présentant respectivement une tige (32) et une structure de maintien (34),
- et les douilles d'insertion (30) sont insérées dans des ouvertures (24) superposées dans une surface tournée vers l'extérieur (44) d'au moins un montant (22) disposé verticalement, en insérant les tiges (32) à travers les ouvertures (24),
- dans lequel une prise de retenue est formée entre les structures de maintien (34) des douilles d'insertion (30) et les ouvertures (24).
